Europäisches Patentamt

European Patent Office

Office européen des brevets

(19)

(11) Veröffentlichungsnummer : **0 062 692**
**B1**

(12) **EUROPÄISCHE PATENTSCHRIFT**

(45) Veröffentlichungstag der Patentschrift :
30.12.86

(51) Int. Cl.⁴ : **H 05 K 13/04**, H 05 K   3/22

(21) Anmeldenummer : 81104295.1

(22) Anmeldetag : 04.06.81

(54) **Verfahren und Einrichtung zum Entfernen des Lotes aus den Bohrlöchern von mit Lot beschichteten unbestückten Leiterplatten.**

(30) Priorität : 15.04.81 CH 2512/81

(43) Veröffentlichungstag der Anmeldung :
20.10.82 Patentblatt 82/42

(45) Bekanntmachung des Hinweises auf die Patenterteilung : 30.12.86 Patentblatt 86/52

(84) Benannte Vertragsstaaten :
AT BE CH DE FR GB IT LI NL SE

(56) Entgegenhaltungen :
DE-A- 2 256 252
DE-A- 2 925 347
US-A- 3 045 095
IBM TECHNICAL DISCLOSURE BULLETIN, Band 22,
Nr. 9, Februar 1980, New York. A. AMENDOLA et al.:
"Centrifugal solder dress process" Seite 4044

(73) Patentinhaber : SIEMENS-ALBIS AKTIENGESELLS-
CHAFT
EGA1/Verträge und Patente Postfach
CH-8047 Zürich (CH)
CH LI
Siemens Aktiengesellschaft Berlin und München
Wittelsbacherplatz 2
D-8000 München 2 (DE)
BE DE FR GB IT NL SE AT

(72) Erfinder : Bajka, Imre
Bachenbülacher 8
CH-8172 Niederglatt (CH)
Erfinder : Furrer, Robert
Albisriederstrasse 16
CH-8003 Zürich (CH)

## Beschreibung

Die vorliegende Erfindung betrifft ein Verfahren gemäss dem Oberbegriff des Anspruches 1 sowie eine Einrichtung zur Durchführung des Verfahrens.

Bei der Herstellung von Leiterplatten für gedruckte Schaltungen wird oft abschliessend eine schützende lötbare Beschichtung auf die Platten aufgebracht, um damit u. a. deren Lagerhaltungseigenschaften zu verbessern. Es besteht die Möglichkeit, die Leiterbahnen der Platten nach einem der bekannten Verfahren wie Tauchlöten, Schwallbadlöten etc. mit einer Lotschicht bestimmter Dicke zu belegen. Dabei werden in der Regel jedoch auch die Bohrlöcher und insbesondere durchmetallisierte Löcher der Leiterplatte mit Lot gefüllt, die dann spätestens vor dem Bestücken der Platte mit Bauelementen wieder freigelegt werden müssen. Unter Lot werden im vorliegenden Zusammenhang alle diejenigen Lotlegierungen verstanden, die beim Löten von Leiterplatten üblicherweise Verwendung finden.

Zum Befreien der Bohrlöcher von überschüssigem Lot sind verschiedene Verfahren bzw. Einrichtungen bekannt. So ist eine sogenannte Lotmittelschleuder bekannt, die eine mit Fluxmittel beschichtete Platte aufnimmt, diese in einen geschmolzenes Lot enthaltenden Behälter taucht und nach dem Herausziehen die Platte derart dreht, dass das überschüssige Lot durch Wirkung der Zentrifugalkraft aus den Löchern entfernt wird. Eine derartige Einrichtung erfordert einen beträchtlichen mechanischen Aufwand. Ein weiteres Verfahren ist unter dem Namen Heisslufteinebnung (Hot air solder leveling process) bekanntgeworden (Proceedings of the first printed circuit world convention, volume two, June 5th-8th 1978 : D. Schoenthaler « Solder coating thickness considerations for hot gas solder leveling », pag. 2. 4. 1. bis 2. 4. 8). Dabei werden die Platten in einer Halterung befestigt, in eine Lotschmelze eingetaucht und unmittelbar nach dem Herausziehen auf beiden Seiten mit heisser Druckluft bestrichen, wodurch ebenfalls eine Befreiung der Bohrlöcher von überschüssigem Lot stattfindet. Es zeigt sich, dass ein solches Vorgehen nicht ohne Probleme ist. Für die resultierende Lotschichtstärke in den Bohrlöchern ist bei diesem Verfahren nämlich neben der Lotzusammensetzung, der Lotbadtemperatur, der Verweilzeit im Lotbad und der Ausziehgeschwindigkeit auch der Winkel der Heissluftdüsen zur Plattenebene, deren Abstand von der Platte sowie der Druck und die Temperatur der Heissluft massgebend. Gerade die optimale Einstellung der vier letztgenannten Einflussgrössen kann recht schwierig und je nach Plattenart unterschiedlich sein. Es besteht bei diesem Verfahren auch die Gefahr, dass die Löcher im Bereich ihrer Kanten durch die Druckluft mehr als zulässig vom Lot befreit werden und sich dort eine Oxydation des Leitermaterials einstellt. Ueberdies ist beim Ausblasen mit unkontrolliert herumfliegenden Lotspritzern zu rechnen, die sich z. B. wieder in Bohrlöchern festsetzen können. Im weiteren sind bei einer solchen Einrichtung Vorkehrungen zur Ableitung der beim Blasen herumgewirbelten giftigen Metalldämpfe vorzusehen. Alles in allem erfordert eine nach diesem Verfahren arbeitende Einrichtung einen verhältnismässig grossen Aufwand an Platz und Apparaturen, weshalb deren Integration in eine möglichst weitgehend automatisierte Leiterplattenfertigungsstrasse nicht ohne weiteres möglich ist. Allein schon die Bereitstellung der heissen Druckluft und ein entsprechend hoher Energieverbrauch lassen einen wirtschaftlich vertretbaren Einsatz dieses Verfahrens unter Umständen fraglich erscheinen.

Aufgabe der vorliegenden Erfindung ist es daher, ein Verfahren anzugeben, das den genannten Schwierigkeiten Rechnung trägt und das in einfacher Weise ein einwandfreies Befreien (Auszinnen) der Bohrlöcher von überschüssigem Lot ohne Beeinträchtigung von deren Löteigenschaften ermöglicht. Die Lösung der Aufgabe gelingt erfindungsgemäss mit einem Verfahren, wie es im Anspruch 1 gekennzeichnet ist. In weiteren Ansprüchen sind vorteilhafte Ausgestaltungen des Verfahrens sowie eine Einrichtung zur Durchführung des Verfahrens angegeben.

Nachfolgend wird das erfindungsgemässe Verfahren und eine Einrichtung zu dessen Durchführung anhand von Zeichnungen beispielsweise näher erläutert. Es zeigt :

Figur 1 die wesentlichen Einheiten einer Einrichtung zur Durchführung des Verfahrens.

Figur 2 Einzelheiten desjenigen Teils dieser Einrichtung, in der die Bohrlöcher der vorverzinnten Leiterplatten von überschüssigem Lot befreit werden.

Figur 3 das generelle Ablaufschema einer vollständigen Verzinn- und Auszinnanlage, in der das Verfahren anwendbar ist.

Figur 4 und 5 je eine weitere Variante einer das erfindungsgemässe Verfahren verwendenden Anordnung.

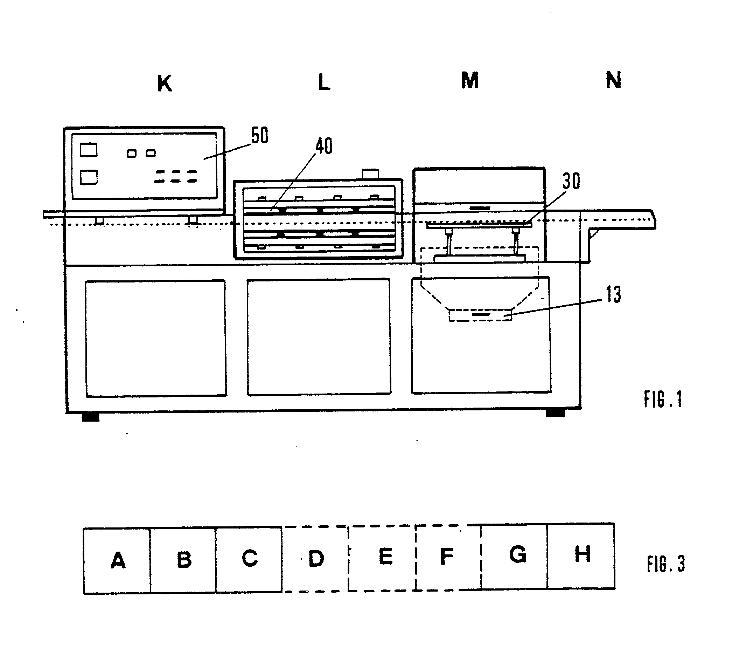

Die Einrichtung gemäss Fig. 1 besteht aus vier Stationen, nämlich einer Bereitstellstation K, einer Aufheizstation L, einer Auszinnstation M und einer Ausgabestation N. Diese Einrichtung dient der Verarbeitung bereits vorverzinnter Leiterplatten, wobei die Verarbeitung darin besteht, die Bohrlöcher der Leiterplatten von überschüssigem Lot zu befreien und diese damit zur Bestückung mit Bauelementen vorzubereiten. Das Vorverzinnen der Leiterplatten erfolgt in bekannter und daher nicht näher beschriebener Weise z. B. mittels Tauchlöten oder Schwallöten. Die vorverzinnten Leiterplatten gelangen nach der Beaufschlagung mit einem Flussmittel in die Bereitstellstation K, von wo aus sie die Einrichtung in einem vorgegebenen Takt selbsttätig horizontal bis zur Ausgabestation N durchlaufen. Die Taktzeiten wie auch andere für den Verarbeitungsablauf massgebende Grössen sind an einem Steuergerät 50 einstellbar. Eine in die Bereitstellstation K eingegebene Leiterplatte gelangt dort zunächst in eine Wartestellung. Sobald es der Ablaufzyklus zulässt, wird die Leiterplatte taktgerecht einem entlang der punktierten horizontalen Linie durch die Einrichtung hindurchlaufenden Transportsystem übergeben und in die Aufheizstation L überführt. Diese besteht beispielsweise aus einem aufheizbaren geschlossenen Raum. Als Wärmeenergiequelle können Infrarotstrahler 40 vorgesehen sein, die die horizontal eingeschobene Leiterplatte auf ihrer ganzen Oberfläche von unten und/oder von oben anstrahlen. Die Temperatur in der Aufheizstation L ist wahlweise einstellbar, ebenso ist der Abstand der Strahler 40 von der Oberfläche der Leiterplatte veränderbar. Selbstverständlich sind zum Schmelzen des Lotes auf der Leiterplatte auch andere bekannte Methoden, wie z. B. Eintauchen der Leiterplatte in Lötöl oder in eine Lotschmelze etc., anwendbar. Sobald nach einer bestimmten Verweilzeit einer Leiterplatte die Lotschmelztemperatur erreicht ist, wird die Leiterplatte zum Entfernen des flüssigen Lotes aus den Bohrlöchern in die Auszinnstation M geschoben, die im wesentlichen aus einer verschiebbaren Halterung 30 für die Leiterplatte und einem darunterliegenden Behälter 13 besteht.

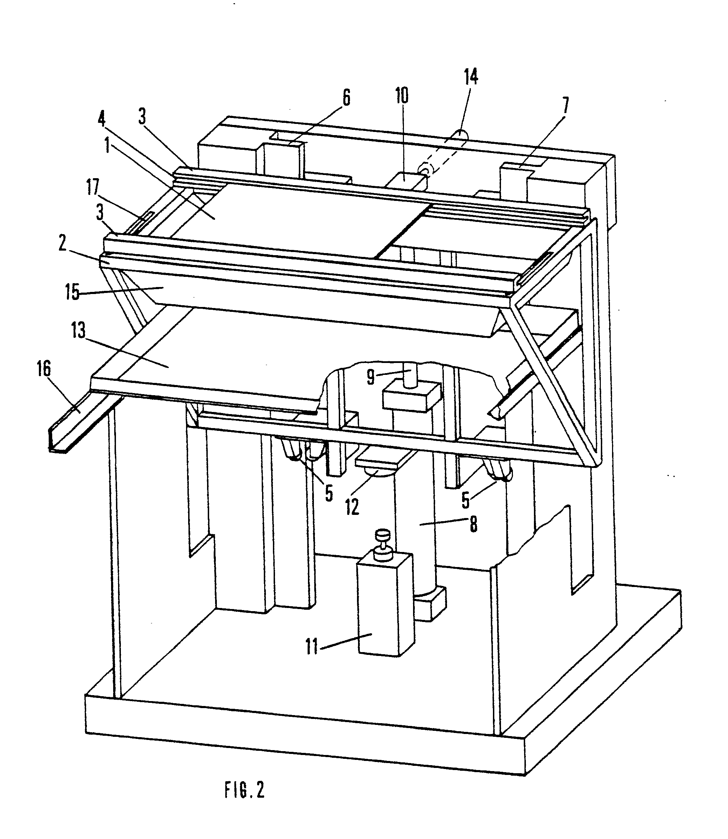

Einzelheiten der Auszinnstation M sind, soweit sie zur Erläuterung des erfindungsgemässen Verfahrens von Bedeutung sind, in Fig. 2 wiedergegeben. Die Leiterplatte 1 wird von der Aufheizstation L her auf einen geführten Rahmen 2 mit zwei parallelen Halteschienen 3 geschoben. Die Halteschienen 3 weisen je eine Nut 4 auf, in die die Leiterplatte 1 horizontal eingeführt wird. Die eine Halteschiene 3 ist starr mit dem Rahmen 2 verbunden, während die andere Halteschiene 3 parallel verschiebbar ist, damit Leiterplatten 1 unterschiedlicher Abmessungen eingeführt werden können. Hiezu sind in den beiden senkrecht zu den Halteschienen 3 verlaufenden Teilen des Rahmens 2 Schlitze 17 vorgesehen, in die an der verschiebbaren Halteschiene angebrachte lösbare Befestigungsmittel eingreifen, die jedoch in der Figur nicht sichtbar sind. Zusätzlich sind die Halteschienen 3 in nicht weiter gezeigter Weise vorteilhaft so konstruiert, dass die Breite der Nut 4 frei einstellbar ist und somit an unterschiedliche Dicken der Leiterplatte 1 angepasst werden kann. Am Rahmen 2 sind ferner 4 Sätze zu je 3 Führungsrollen 5 angebracht, von denen nur die zwei unteren sichtbar sind.

Jeweils 2 Sätze der Führungsrollen 5 sind auf einer vertikal zur Leiterplattenebene verlaufenden Schiene 6 bzw. 7 geführt. Die Schienen 6, 7 verlaufen parallel zueinander und sind starr mit dem Träger der Auszinnstation M (Fig. 1) verbunden. Somit ist der ganze Rahmen 2 entlang der Schienen 6, 7 vertikal verschiebbar. Die Bewegung des Rahmens 2 erfolgt über einen Hubzylinder 8. Hierzu liegt der Rahmen 2 an einem Auflager 10 auf einem Kolbenfortsatz 9 des Hubzylinders 8 auf. Ferner ist ein Dämpfungsorgan 11 vorhanden, auf dem der Rahmen 2 mit einem Anschlag 12 nach Erreichen seiner untersten Stellung aufliegt. Im weiteren ist am Rahmen 2 ein auf Schienen 16 herausziehbarer Behälter 13 angeordnet, der sich wenigstens über die ganze Fläche der Leiterplatte 1 erstreckt, derart, dass von der Leiterplatte 1 abfallendes Lot direkt in den Behälter 13 gelangt. Ein Kragen 15 mit leicht nach innen geneigten Seitenflächen begünstigt die Aufnahme abfallenden Lotes im Behälter 13.

Die Behandlung einer in diese Auszinnstation gelangenden Leiterplatte 1 geht wie folgt vor sich : Der Rahmen 2 befindet sich beim Eintreffen der Leiterplatte 1 in seiner obersten Lage und wird dort durch den in das Auflager 10 eingreifenden Kolben eines weiteren Zylinders 14 gehalten. Der Kolbenfortsatz 9 des Hubzylinders 8 hingegen ist in seiner unteren Ausgangsstellung. Sobald die von der Aufheizstation L kommende Leiterplatte 1 vollständig in die Halteschienen 3 eingeschoben ist, wird die Arretierung des Rahmens 2 durch Betätigung des Zylinders 14 aufgehoben, was einen vertikalen Fall des Rahmens 2 mitsamt der Leiterplatte 1 zur Folge hat. Der Rahmen 2 prallt mit seinem Anschlag 12 auf das Dämpfungsorgan 11 auf und wird abgebremst. Dadurch wird das sich in den Bohrlöchern der Leiterplatte 1 befindliche überschüssige Lot, das aufgrund der Erwärmung in der Aufheizstation L sich noch immer im geschmolzenen Zustand befindet, nach unten aus den Löchern geschlagen und im Behälter 13 aufgefangen. Hierauf wird der Rahmen 2 durch den Hubzylinder 8 wieder in seine Ausgangslage gehoben. Die vom überschüssigen Lot befreite Leiterplatte 1 wird hierauf nach Abkühlung auf eine das auf der Leiterplatte 1 verbliebene Lot erstarrende Temperatur in die Ausgabestation N (Fig. 1) überführt, von wo aus sie dann in bekannter und daher nicht weiter beschriebener Weise einem Reinigungsprozess unterzogen wird. Der Rahmen 2 ist hierauf zur Aufnahme einer neuen Leiterplatte 1 aus der Aufheizstation L bereit. Die Praxis zeigt, dass mit dem beschriebenen Vorgehen einwandfreie Leiterplatten erhalten werden. So genügen die Lotschichtdicken an den kritischen Stellen im Bereich der Bohrlöcher und insbesondere die Lochkanten hohen Anforderungen. Die Einrichtung gemäss Fig. 2 zum Auszinnen der Leiterplatten lässt sich ohne Schwierigkeiten in eine vollautomatisierte Fertigungsstrasse einfügen ; sie erfordert keinen nennenswerten Bedienungsaufwand und sie lässt sich sehr einfach und rasch an unterschiedliche Plattengrössen anpassen.

Selbstverständlich sind auch anders ausgebildete Einrichtungen zur Durchführung des Verfahren denkbar, die an die Gegebenheiten der jeweiligen Fertigungsstrasse angepasst sind. Die Betätigung der beiden Zylinder kann über eine handelsübliche frei programmierbare Steuerung erfolgen.

Der Behälter 13 muss nicht unbedingt mit dem Rahmen 2 verbunden sein ; er könnte auch selbständig unter dem Rahmen 2 im Fallbereich der Leiterplatte 1 angeordnet sein, wie dies in der Auszinnstation M nach Fig. 1 angedeutet ist. Allerdings zeigt die Praxis eine Verbesserung in bezug auf die Qualität der ausgezinnten Bohrlöcher, wenn der Behälter 13 wie beschrieben mit dem Rahmen 2 verbunden ist und demzufolge die Fallbewegung der Leiterplatte 1 mitmacht. Die Bodenfläche des Behälters 13 liegt in einem bestimmten Abstand parallel zur Leiterplattenfläche und ist vorzugsweise mit einem Material (z. B. Metallwatte) belegt, das die Aufprallenergie der nach unten geschlagenen Lotteile möglichst vollständig absorbiert. In einer derartigen Anordnung befindet sich unmittelbar unter der Leiterplatte 1 ein Raum mit stationärer Luft, der beim Beschleunigen der Leiterplatte 1 mitbewegt wird. Im Vergleich zu einer Anordnung mit einem selbständigen Behälter 13 wird die Leiterplatte 1 daher beim Hinunterfallen viel weniger eine Luftströmung von unten ausgesetzt, weshalb sie sich auch weniger schnell abkühlt. Demzufolge werden die Bohrlöcher gleichmässiger ausgezinnt.

Eine weitere Verbesserung wird erreicht, wenn der Boden des mit dem Rahmen 2 fest verbundenen Behälters 13 derart mehrteilig ausgebildet ist, dass er sich beim Aufschlag des Rahmens 2 nach unten öffnet und erst nach dem Aufprall wieder geschlossen wird. Der Boden kann beispielsweise der Länge nach in zwei Hälften aufgeteilt werden, die beim Aufprall des Rahmens 2 nach Art einer aus 2 Flügeln bestehenden Schwingtüre nach unten ausgelenkt und hierauf durch Rückstellfedern wieder in ihre den geschlossenen Boden bildende Ausgangslage gebracht werden. Beim Oeffnen des Bodens entsteht im Raum unter der Leiterplatte 1 eine Sogwirkung, die den Auszinnvorgang noch begünstigt. Zudem wird das überschüssige Lot nicht eigentlich im Behälter 13 aufgefangen, sondern es verlässt diesen durch den geöffneten Boden, wodurch ein Zurückspritzen von Lotteilen verhindert wird.

In der Praxis kann der Fall eintreten, dass das einmalige Abschlagen der Leiterplatte nicht immer ein optimales Ergebnis hinsichtlich der Lotschicht im Bereich der Löcher der Leiterplatte ergibt. Es ist dann von Vorteil, die Leiterplatte unmittelbar aufeinanderfolgend mehr als einmal zu beschleunigen und aufprallen zu lassen.

Bei zweimaligem Beschleunigen erweist es sich als zweckmässig, die erste Fallstrecke kürzer zu wählen als die zweite. Damit wird erreicht, dass beim ersten Aufprall mit geringer Energie bereits grosse Mengen des Lotes aus den Löchern entfernt werden. Beim zweiten Aufprall aus grösserer Höhe werden dann nur noch kleinere Mengen von Lot abgeschlagen und die vor allem im Falle beidseitig kaschierter Leiterplatten allenfalls entgegen der Bewegungsrichtung der Leiterplatte — d. h. nach oben — noch austretenden Lotspritzer sind dann in Anzahl und Grösse so klein, dass sie im anschliessenden Reinigungsprozess ohne weiteres entfernt werden können. Ein zweimaliges Abschlagen der Leiterplatte 1 lässt sich durch entsprechende Steuerung des Hubzylinders 8 relativ einfach realisieren. Sobald die Leiterplatte 1 in der obersten Stellung des auf dem Kolbenfortsatz 9 abgestützten Rahmens 2 eingeschoben ist, wird der Kolben kontinuierlich nach unten bewegt, bis die gewünschte Fallhöhe für das erstmalige Abschlagen erreicht ist. Hierauf wird der Kolben schlagartig in seine untere Ausgangslage gebracht, wodurch der Rahmen 2 in einem geführten freien Fall eine Beschleunigung nach unten erfährt, bis er auf das Dämpfungsorgan 11 auftrifft. Anschliessend wird der Rahmen 2 durch entsprechende Betätigung des Hubzylinders 8 erneut auf eine gewünschte zweite Fallhöhe — die wie erwähnt vorzugsweise grösser ist als die erste Fallhöhe — angehoben und in gleicher Weise wiederum einem freien Fall ausgesetzt. Zur Realisierung des zwei- oder auch mehrmaligen Abschlagens der Leiterplatte 1 ist also lediglich eine entsprechende Ansteuerung des Hubzylinders 8 notwendig, was ohne nennenswerte Schwierigkeiten über eine programmierbare Steuerung möglich ist.

Entgegen dem anhand von Fig. 2 beschriebenen Beispiel, wo die Leiterplatte 1 im freien Fall beschleunigt wird, lässt sich die Leiterplatte 1 auch in einem gesteuerten vertikalen Fall beschleunigen. Hierzu bedarf es einer besonderen Steuerung des Hubzylinders 8, indem dessen Kolben mit einer vorgegebenen Beschleunigung nach unten bewegt wird und demzufolge der während dem ganzen Bewegungsablauf auf dem Kolbenfortsatz 9 aufliegende Rahmen 2 mit der Leiterplatte 1 eine entsprechende Beschleunigung nach unten erfährt. Die notwenigen Beschleunigungswerte sind in erster Linie abhängig von der Ausgestaltung der Leiterplatte sowie von der jeweils abzuschlagenden Menge überschüssigen Lotes. Deren Ermittlung muss daher empirisch erfolgen.

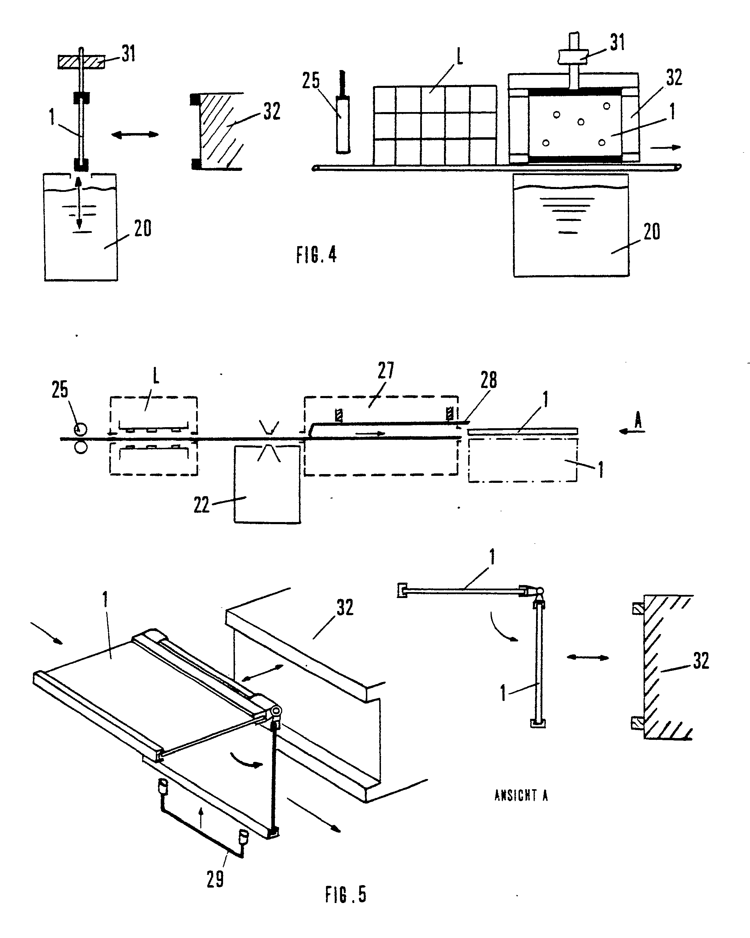

In der bisherigen Beschreibung wurde davon ausgegangen, dass die metallisierten Bereiche der auszuzinnenden Leiterplatten bereits mit Lot beschichtet sind und diese im kalten Zustand zur Auszinnstation gelangen. Das erfindungsgemässe Vorgehen zum Entfernen des überschüssigen Lotes lässt sich jedoch auch dort vorteilhaft einsetzen, wo die Leiterplatten in einem Zug mit Lot beaufschlagt und unmittelbar darauf, d. h. ohne zwischenzeitliche Abkühlung, von überschüssigem Lot befreit werden. Zur näheren Erläuterung dieses Anwendungsfalles ist in Fig. 3 schematisch der Ablauf in einer Fertigungsstrasse zum Verzinnen und Auszinnen von Leiterplatten dargestellt. Wird das Verzinnen und Auszinnen nicht in einem Zug, sondern in zwei getrennten Abläufen durchgeführt, dann ergeben sich folgende einzelne Phasen : Zum Verzinnen werden die Leiterplatten in einer Phase A mit dem Flussmittel beaufschlagt, in einer Phase B vorgewärmt und in einer Phase C ein- oder beidseitig verzinnt. Zum anschliessenden Auszinnen, das zu einem beliebigen Zeitpunkt nach dem Verzinnen erfolgen kann, werden die Leiterplatten in einer Phase D wiederum mit dem Flussmittel beaufschlagt, in einer Phase E bereitgestellt, in einer Phase F auf eine das Zinn schmelzende Temperatur aufgeheizt, in einer Phase G nach dem erfindungsgemässen Verfahren vom überschüssigen Lot befreit und schliesslich in einer Phase H zur weiteren Verarbeitung ausgegeben. Soll nun das Verzinnen und Auszinnen in einem ununterbrochenen Ablauf ohne zwischenzeitliches Abkühlen der Leiterplatte durchgeführt werden, dann entfallen die erwähnten Phasen D, E, und F beim Auszinnen. Die Leiterplatte muss vor dem Auszinnen nicht erneut erwärmt werden, da sie unmittelbar nach dem Verzinnen mit dem noch flüssigen Lot der Auszinnstation zugeführt und dort von überschüssigem Lot befreit wird. In diesem Fall ist nur ein Teil der Auszinneinrichtung nach Fig. 1, nämlich die Entzinnstation M und die Ausgabestation N notwendig, die die Phasen G und H im Ablaufschema nach Fig. 3 übernehmen.

Die Anwendung des beschriebenen Prinzips zum Auszinnen von Leiterplatten ist keineswegs auf das vorstehend beschriebene Beispiel mit vertikalem Fall der Leiterplatte in horizontaler Lage beschränkt. Die Grundidee des Verfahrens, nämlich das Auszinnen durch « Abschlagen », lässt sich in weiteren Varianten anwenden. In Fig. 4 ist eine denkbare Variante in zwei Seitenansichten skizziert, bei der das Vorverzinnen von Leiterplatten 1 oder das Schmelzen des Lotes bereits vorverzinnter Leiterplatten 1 durch vertikales Eintauchen in ein Lotschmelzbad 20 erfolgt, wobei die Leiterplatte 1 zuvor noch mit einem Flussmittel 25 beaufschlagt und in einer Aufheizstation L vorgewärmt werden kann. Die Leiterplatte 1 wird hierauf senkrecht nach oben herausgezogen und trifft auf einem Anschlag 31 auf. Dabei wird zunächst einmal das entlang der Leiterplattenoberfläche nach unten fliessende überschüssige Lot in das Lotschmelzbad 20 abgeschlagen. Hierauf wird die Leiterplatte 1 in zur Ausziehrichtung senkrechter Richtung relativ zu einer weiteren Aufschlagstelle 32 beschleunigt und dann abgebremst, wobei beim Aufprall die Bohrlöcher noch vollständig von überschüssigem Lot befreit werden. Unmittelbar darauf wird die Leiterplatte 1 in die horizontale Lage gebracht, wodurch sich beim Abkühlen der Leiterplatte eine gleichmässige Lotverteilung vor allem im Bereich der die Bohrlöcher umgebenden Lötaugen ergibt. Selbstverständlich lässt sich bei Bedarf bei dieser Variante ohne weiteres auch ein mehrmaliges Beschleunigen der Leiterplatte in vertikaler und/oder in horizontaler Richtung vorsehen.

Eine weitere Variante des Verfahrens, bei der das Beaufschlagen der Leiterplatten 1 mit Lot oder das Schmelzen des Lotes bereits vorverzinnter Leiterplatten 1 in einem Schwallbad erfolgt, ist in Fig. 5 skizziert. Dabei wird die Leiterplatte 1 in horizontaler Lage mit einem Flussmittel 25 beaufschlagt, in einer Aufheizstation L vorgewärmt und dann weiterhin in horizontaler Lage durch das Schwallbad 22 hindurchgezogen. Anschliessend gelangt die verzinnte Leiterplatte 1 in eine Warmhaltestation 27 und wird hierauf mittels einer Greifvorrichtung 28 raschmöglichst aus dieser herausgezogen und um 90° gedreht, so dass sie nun senkrecht zur Transportebene steht. Darauf erfolgt wiederum wie in der Anordnung gemäss Fig. 4 zunächst ein Abschlagen in Richtung der Leiterplattenebene (z. B. von unten mit einem Stössel 29) und anschliessend ein Abschlagen in einer zur Leiterplattenebene senkrechten Richtung. Die Warmhaltestation 27 dient dazu, ein Abkalten der Leiterplatte 1 zu verhindern, bevor diese das Schwallbad 22 vollständig durchlaufen hat und abgeschlagen werden kann. Auch hier ist ein mehrmaliges Abschlagen der Leiterplatte 1 möglich.

**Patentansprüche**

1. Verfahren zum Entfernen von überschüssigem Lot aus den Bohrlöchern einer unbestückten Leiterplatte, dadurch gekennzeichnet, dass die Leiterplatte in einem Zustand, in dem das aufgebrachte Lot geschmolzen ist, wenigstens einmal beschleunigt und hierauf derart schlagartig zum Stillstand gebracht wird, dass das überschüssige Lot aus allen Bohrlöchern gleichzeitig herausgeschlagen wird.

2. Verfahren nach Anspruch 1, dadurch gekennzeichnet, dass die Leiterplatte der Erdbeschleunigung ausgesetzt und in einer zur Bewegungsrichtung senkrechten Ebene auf einer Aufschlagstelle abgebremst wird.

3. Verfahren nach Anspruch 1 oder 2, dadurch gekennzeichnet, dass die Leiterplatte unmittelbar nach dem ersten Aufschlag ein zweites Mal beschleunigt und wiederum schlagartig abgebremst wird.

4. Verfahren nach Anspruch 3, dadurch gekennzeichnet, dass die erstmalige Beschleunigung der Leiterplatte über eine kürzere Strecke als die anschliessende zweite Beschleunigung erfolgt.

5. Verfahren nach Anspruch 1, dadurch gekennzeichnet, dass die Leiterplatte (1) vertikal in eine Lotschmeize (20) eingetaucht und hierauf in zur Eintauchrichtung entgegengesetzter Richtung herausgezogen und gegen eine erste Aufschlagstelle (31) geschlagen wird und dass die Leiterplatte (1) anschliessend wenigstens einmal in einer zur Ausziehrichtung und zur Plattenebene senkrechten Richtung relativ zu einer weiteren Aufschlagstelle (32) beschleunigt und durch Aufprall auf diese abgebremst wird.

6. Verfahren nach Anspruch 1, dadurch gekennzeichnet, dass die Leiterplatte (1) horizontal durch ein Schwallbad (22) hindurchgezogen, um eine in der Horizontalebene liegende Achse um 90 Grad gedreht und dann in einer in der Leiterplattenebene liegenden Richtung relativ zu einer ersten Aufschlagstelle (29) beschleunigt wird und dass die Leiterplatte (1) anschliessend wenigstens einmal in einer zur Leiterplattenebene senkrechten Richtung relativ zu einer weiteren Aufschlagstelle (32) beschleunigt und durch den Aufprall auf diese abgebremst wird.

7. Einrichtung zur Durchführung des Verfahrens nach Anspruch 1, dadurch gekennzeichnet, dass ein Rahmen (2) mit Mitteln (3) zur Aufnahme wenigstens einer Leiterplatte (1) vorgesehen ist, der entlang einer Führung beliebig verschiebbar und einer Beschleunigung relativ zu einer Aufschlagstelle (11) aussetzbar ist.

8. Einrichtung nach Anspruch 7, dadurch gekennzeichnet, dass der Rahmen (2) zur Aufnahme der Leiterplatte (1) in horizontaler Lage ausgebildet und entlang von 2 parallelen vertikalen Führungsschienen (6, 7) geführt ist, dass der Rahmen (2) mittels mindestens einem steuerbaren Hubzylinder (8) entlang der Führungsschienen (6, 7) in jede beliebige Lage zwischen einer unteren und oberen Grenzlage hebbar ist und hierauf unter Einwirkung des Hubzylinders (8) oder durch Aufheben der Wirkung des Hubzylinders (8) aus einer beliebigen Lage im vertikalen Fall entlang der Führungsschienen (6, 7) auf die Aufschlagstelle (11) gelangt.

9. Einrichtung nach Anspruch 8, dadurch gekennzeichnet, dass im Fallbereich des Rahmens (2) ein Behälter (13) zur Aufnahme der beim Aufprall des Rahmens (2) aus den Bohrlöchern der Leiterplatte (2) herausgeschlagenen Lotteile vorgesehen ist.

10. Einrichtung nach Anspruch 9, dadurch gekennzeichnet, dass der Behälter (13) in einem bestimmten Abstand unter der Leiterplattenebene mit dem Rahmen (2) verbunden ist.

11. Einrichtung nach Anspruch 10, dadurch gekennzeichnet, dass der Boden des Behälters (13) aus wenigstens zwei Teilen besteht, die beim Aufschlag des Rahmens (2) nach unten gedrückt werden und damit den Boden des Behälters (13) öffnen und die nach dem Stillstand des Rahmens (2) durch die Wirkung von Federkräften wieder ihre den Boden schliessende Ausgangsstellung einnehmen.

## Claims

1. A method of removing excess solder from the boreholes of an unequipped circuit board, characterised in that the circuit board is accelerated at least once in a state in which the applied solder is molten, and is thereafter suddenly brought to a halt in such a way that the excess solder is simultaneously driven out from all the boreholes.

2. A method as claimed in Claim 1, characterised in that the circuit board is subjected to acceleration due to gravity and decelerated at a point of impact in a plane at right angles to the direction of movement.

3. A method as claimed in Claim 1 or Claim 2, characterised in that the circuit board is accelerated for a second time immediately after the first impact and again suddenly decelerated.

4. A method as claimed in Claim 3, characterised in that the first acceleration of the circuit board is effected over a shorter length than the subsequent second acceleration.

5. A method as claimed in Claim 1, characterised in that the circuit board (1) is vertically immersed in a solder melt (20) and is then withdrawn in the direction opposite to the direction of immersion and knocked against a first point of impact (31) ; and that the circuit board (1) is subsequently accelerated at least once in a direction at right angles to the direction of withdrawal and to the plane of the board, relative to a further point of impact (32) and decelerated by impact on said further point of impact (32).

6. A method as claimed in Claim 1, characterised in that the circuit board (1) is horizontally drawn through a swell bath (22), rotated through 90° about an axis in the horizontal plane and then accelerated in a direction in the plane of the circuit board, relative to a first point of impact (29) ; and that the circuit board (1) is subsequently accelerated at least once in a direction which is at right angles to the plane of the circuit board, relative to a further point of impact (32) and decelerated by impact on said further point of impact (32).

7. Apparatus for carrying out the method as claimed in Claim 1, characterised in that there is provided a frame (2) having means (3) for accommodating at least one circuit board (1), which frame is arbitrarily displaceable along a guide and can be subjected to an acceleration relative to a point of impact (11).

8. Apparatus as claimed in Claim 7, characterised in that the frame (2) is arranged for accommodating the circuit board (1) in the horizontal position and guided along 2 parallel vertical guide rails (6, 7) ; that the frame (2) can be lifted into any position between a lower and an upper limit position along the guide rails (6, 7) by means of at least one controllable lifting cylinder (8), and under the influence of the lifting cylinder (8), or by cancelling the effect of the lifting cylinder (8), subsequently falls vertically on to the impact point (11) from any position along the guide rails (6, 7).

9. Apparatus as claimed in Claim 8, characterised in that in the falling region of the frame (2) a container (13) is arranged to accommodate the solder portions which are knocked out of the boreholes of the circuit board (2) on the impact of the frame (2).

10. Apparatus as claimed in Claim 9, characterised in that the container (13) is fixed to the frame (2) at a specific distance below the plane of the circuit board.

11. Apparatus as claimed in Claim 10, characterised in that the base of the container (13) consists of at least two parts, which on the impact of the frame (2) are pressed downwardly and thus open the base of the container (13) and which after the halting of the frame (2), re-assume their initial position, to close the base, under the influence of spring forces.

## Revendications

1. Procédé pour éliminer la soudure excédentaire des perçages d'une plaquette à circuits imprimés non équipée, caractérisé par le fait qu'on accélère au moins une fois la plaquette à circuits imprimés située dans un état, dans lequel la soudure déposée sur la plaquette est fondue, et qu'on l'amène alors brusquement à l'arrêt de telle sorte que la soudure excédentaire est éjectée simultanément de tous les perçages.

2. Procédé suivant la revendication 1, caractérisé par le fait qu'on soumet la plaquette à circuits imprimés à l'accélération de la pesanteur et qu'on la freine, dans un plan perpendiculaire à la direction de déplacement, contre une butée.

3. Procédé suivant la revendication 1 ou 2, caractérisé par le fait que directement après le premier choc on accélère une seconde fois la plaquette à circuits imprimés et qu'on la freine à nouveau brusquement.

4. Procédé selon la revendication 3, caractérisé en ce que la première accélération de la plaquette à circuits imprimés est réalisée sur une distance plus courte que la seconde accélération ultérieure.

5. Procédé suivant la revendication 1, caractérisé par le fait qu'on immerge la plaquette à circuits imprimés (1) verticalement dans une masse de soudure fondue (20), qu'on la retire ensuite dans une direction opposée à la direction d'immersion et qu'on la projette contre une première butée (31) et qu'on accélère ensuite au moins une fois la plaquette à circuits imprimés (1) suivant une direction perpendiculaire à la direction d'extraction et perpendiculaire au plan de la plaquette, par rapport à une seconde butée (32) et que la plaquette est freinée par choc sur cette butée.

6. Procédé suivant la revendication 1, caractérisé par le fait qu'on fait passer la plaquette à circuits imprimés (1) horizontalement à travers un bain à la vague (22), qu'on la fait pivoter de 90 degrés autour d'un axe situé dans le plan horizontal, qu'on l'accélère ensuite suivant une direction située dans son plan, par rapport à une première butée (29) et qu'ensuite on accélère au moins une fois la plaquette à circuits imprimés (1) suivant une direction perpendiculaire à son plan, par rapport à une seconde butée (32), et que la plaquette est freinée par choc sur cette butée.

7. Dispositif pour la mise en œuvre du procédé suivant la revendication 1, caractérisé par le fait qu'il est prévu un cadre (2) comportant des moyens (3) servant à recevoir au moins une plaquette à circuits imprimés (1) qui est déplaçable à volonté le long d'un guide et susceptible d'être accélérée par rapport à une butée (11).

8. Dispositif suivant la revendication 7, caractérisé par le fait que le cadre (2) est réalisé pour recevoir la plaquette à circuits imprimés (1) en position horizontale et est guidé le long de 2 rails de guidage verticaux parallèles (6, 7), que le cadre (2) peut être soulevé au moyen d'un vérin élévatoire (8) pouvant être commandé, le long des rails de guidage (6, 7), pour être amené dans n'importe quelle position entre une position limite inférieure et une position limite supérieure, et tombe ensuite à partir d'une position quelconque sur la butée (11), selon une chute verticale le long des rails de guidage (6, 7) sous l'action du vérin élévatoire (8) ou avec suppression de l'action du vérin élévatoire (8).

9. Dispositif suivant la revendication 8, caractérisé par le fait que dans la zone de chute du cadre (2), il est prévu un récipient (13) servant à recevoir les particules de soudure projetées hors des perçages de la plaquette à circuits imprimés (2) lors du choc du cadre (2).

10. Dispositif suivant la revendication 9, caractérisé par le fait que le récipient (13) est relié au cadre (2) en étant situé à une distance déterminée au-dessous du plan de la plaquette à circuits imprimés.

11. Dispositif suivant la revendication 10, caractérisé par le fait que le fond du récipient (13) est constitué d'au moins deux éléments qui, lors du choc du cadre (2), sont repoussés vers le bas et ouvrent par conséquent le fond du récipient (13) et reprennent, après l'arrêt du cadre (2), leur position initiale fermant le fond, sous l'action de forces élastiques.

K          L          M          N

FIG. 1

FIG. 3

| A | B | C | D | E | F | G | H |

1

FIG.2

FIG. 4

ANSICHT A

FIG. 5